# EUROPEAN PATENT APPLICATION

(11) **EP 2 808 904 A1**
(43) Date of publication of application: **03.12.2014**
(21) Application number: 13754351.8
(22) Date of filing: 25.02.2013
(51) Int. Cl.: H01L 31/04, C23C 14/34

(54) **METHOD FOR MANUFACTURING COMPOUND SOLAR CELL**

(30) Priority: 27.02.2012 JP 2012040151
(71) Applicant: Nitto Denko Corporation, Ibaraki-shi, Osaka 567-8680 (JP)
(72) Inventor: TERAJI Seiki, Ibaraki-shi Osaka 567-8680 (JP); KAWAMURA Kazunori, Ibaraki-shi Osaka 567-8680 (JP); NISHII Hiroto, Ibaraki-shi Osaka 567-8680 (JP); WATANABE Taichi, Ibaraki-shi Osaka 567-8680 (JP)
(74) Representative: Hoffmann Eitle
(86) International application number: PCT/JP2013/054721
(87) International publication number: WO 2013/129297

(57) **Abstract**

In order to provide a method that can manufacture a compound solar cell with a high conversion efficiency at low cost, a buffer layer is formed by a sputtering method with the use of a high-frequency RF power source or a high-frequency RF power source and a direct-current (DC) power source in combination, while two cathode targets 6, 6' for sputtering are arranged to be opposed to each other on both sides of an imaginary central axis x assumed to extend perpendicularly from a surface of a substrate 1 over with a CIGS light absorbing layer 3 is stacked.

## Description

### TECHNICAL FIELD

The present invention relates to a method for efficiently manufacturing a compound solar cell which is high in light conversion efficiency (hereinafter, referred to as "conversion efficiency"), with the use of CuInSe₂ (CIS) composed of elements from Groups IB, IIIB, and VIB or Cu(In,Ga)Se₂ (CIGS) compound semiconductors with Ga therein present as solid solutions (Group I-III-VI compound semiconductors) for a light absorbing layer.

### BACKGROUND ART

Among solar cells, compound solar cells which use CIS or CIGS (hereinafter, referred to as "CIGS") compound semiconductors for light absorbing layers are known to be high in light conversion efficiency, able to be formed into thin films, and advantageous in that the conversion efficiency is less likely to be degraded due to light irradiation or the like.

For a buffer layer of a compound solar cell using such a CIGS compound semiconductor for a light absorbing layer, CdS, Zn(O,S), or the like formed by a chemical deposition method is typically used (for example, see Patent Document 1). However, in the case of forming the buffer layer by the chemical deposition method, it is necessary to form a CIGS compound semiconductor layer under vacuum, then once extract the layer under the atmosphere, form the buffer layer, and form a transparent electrode layer again under vacuum, and there is the problem of poor productivity.

Therefore, in order to solve this problem, it has been proposed that the buffer layer in the compound solar cell mentioned above is formed continuously by a sputtering method under vacuum without the extraction under the atmosphere (for example, see Patent Document 2).

### CITATION LIST

### PATENT LITERATURE

PLT1: JP-A-2002-343987
PLT2: JP-A-2002-124688

### SUMMARY OF INVENTION

### PROBLEMS TO BE SOLVED BY THE INVENTION

However, it has turned out that when the buffer layer is formed continuously under vacuum with the use of a magnetron sputtering system widely used as a sputtering system, as in Patent Document 2, negative ions and high-energy electrons in plasma generated by sputtering damage the buffer layer and the light absorbing layer to cause a new problem of degrading characteristics of the compound solar cell, while the conversion efficiency is improved. This is particularly significant when the electric power applied to a cathode target is increased in order to improve the productivity, and improvements therefor have been strongly desired.

The present invention has been achieved in view of the problem mentioned above, and an object of the present invention is to provide a compound solar cell including a buffer layer which can be formed continuously under vacuum without any extraction under the atmosphere, moreover with a high conversion efficiency.

### SOLUTIONS TO THE PROBLEMS

In order to achieve the object mentioned above, the present invention includes a method for manufacturing a compound solar cell including at least a Group I-III-VI compound semiconductor layer, a buffer layer, and a transparent electrode layer in this order over a substrate, and the method for manufacturing a compound solar cell is characterized in that the buffer layer is formed by a sputtering method with the use of a high-frequency RF power source or a combination of a high-frequency RF power source with a direct-current (DC) power source, while two cathode targets for sputtering are arranged to be opposed to each other on both sides of an imaginary central axis assumed to extend perpendicularly from a surface of the substrate over which the Group I-III-VI compound semiconductor layer is stacked.

### EFFECTS OF THE INVENTION

The method for manufacturing a compound solar cell according to the present invention consists in a method for manufacturing a compound solar cell including at least a Group I-III-VI compound semiconductor layer, a buffer layer, and a transparent electrode layer in this order, where the buffer layer is formed by a special sputtering method. For this reason, following the formation of the Group I-III-VI compound semiconductor layer, the buffer layer can be formed continuously under vacuum, and the production efficiency of the compound solar cell can be increased. Moreover, the buffer layer is formed by the sputtering method with the use of a high-frequency RF power source or a combination of a high-frequency RF power source with a direct-current (DC) power source, while the two cathode targets for sputtering are arranged to be opposed to each other on both sides of the imaginary central axis assumed to extend perpendicular to the surface of the substrate over with the Group I-III-VI compound semiconductor layer is stacked. Thus, electrons, etc. generated can be confined between the both cathode targets, and a balance can be achieved between the formation of the buffer layer at high speed and the reduction in damage caused to the Group I-III-VI compound semiconductor layer. Therefore, the compound solar cell obtained by the manufacturing method according to the present invention is manufactured at low cost, and moreover adapted to be high in conversion efficiency.

In addition, when the two opposed cathode targets are arranged in a substantially V-shaped form which spreads toward the substrate, the buffer layer can be formed at higher speed, and the compound solar cell can be further reduced in cost.

Further, when the two opposed cathode targets are arranged parallel to each other, more electrons generated can be confined between the both cathodes, and the damage caused to the Group I-III-VI compound semiconductor layer can be further reduced.

### BRIEF DESCRIPTION OF DRAWINGS

FIG. 1 is a cross-sectional view of a CIGS solar cell obtained according to an embodiment of the present invention.
FIG. 2 is a diagram illustrating a positional relationship between cathode targets and a substrate in a sputtering system for use in the formation of a buffer layer of the CIGS solar cell.
FIG. 3 is an explanatory diagram illustrating another example of the positional relationship between the cathode targets and substrate in the sputtering system.
FIG. 4 is an explanatory diagram illustrating another example of the positional relationship between the cathode targets and substrate in the sputtering system.

### DESCRIPTION OF EMBODIMENTS

Next, an embodiment for carrying out the present invention will be described.

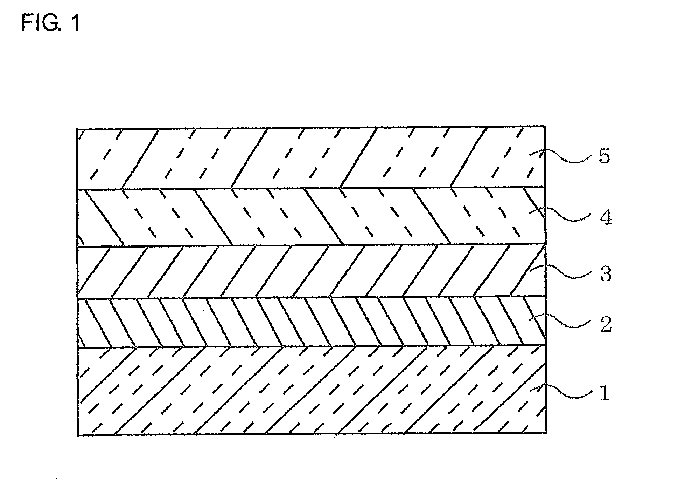

FIG. 1 is a cross-sectional view of a CIGS solar cell obtained according to an embodiment of the present invention. This CIGS solar cell has a size of 20 mm in width × 20 mm in length × 53 µm in thickness, and includes a substrate 1, a rear electrode layer 2 (800 nm in thickness), a CIGS light absorbing layer (compound semiconductor layer) 3 (2 µm in thickness) composed of a chalcopyrite compound, a buffer layer 4 (70 nm in thickness), and a transparent electrode layer 5 (200 nm in thickness) composed of an ITO in this order, and the buffer layer 4 is formed by a special sputtering method. This CIGS solar cell will be described below in detail, along with a manufacturing method therefor. It is to be noted that FIG. 1 is shown schematically in thickness, size, appearance, etc. for each layer, which differs from the actual cell (the same applies to the following drawings).

For the substrate 1, degreased SUS 430 (20 mm in width × 20 mm in length × 50 µm in thickness) is used. Further, the rear electrode layer 2 formed over the substrate 1 is composed of molybdenum (Mo), and this rear electrode layer 2 can be formed by a sputtering method, a vapor deposition method, or an ink-jet method. In this embodiment, a sputtering method is used for the formation.

Furthermore, the CIGS light absorbing layer (compound semiconductor layer) 3 formed over the rear electrode layer 2 is composed of a compound semiconductor containing four elements of copper (Cu), indium (In), gallium (Ga), and selenium (Se). Methods for forming this CIGS light absorbing layer 3 include a vapor deposition method, a selenization/sulfurization method, and a sputtering method. In this embodiment, a multi-source vapor deposition method is used.

Furthermore, in this embodiment, prior to the formation of the CIGS light absorbing layer 3, a minute amount of Na is added by vapor deposition of NaF for 40 nm in thickness on the rear electrode layer 2, and thereafter, the CIGS light absorbing layer 3 is formed as follows. More specifically, Ga, In, Cu, and Se are each placed as vapor deposition sources in a chamber of a vacuum vapor deposition system. Next, the substrate 1 is heated to reach 550°C at a rate of temperature increase of 550°C/h, with the degree of vacuum adjusted to 1 × 10⁻⁴ Pa in the chamber. Then, the CIGS light absorbing layer 3 is formed in such a way that Cu (1100°C), In (780°C), Ga (950°C), and Se (140°C) as the respective vapor deposition sources are respectively heated so as to reach the temperatures in the parentheses, for simultaneously evaporating the respective vapor deposition sources.

It is to be noted that the composition ratio of Cu, In and Ga in the CIGS light absorbing layer 3 preferably satisfies the formula of 0.7 < Cu/ (Ga + In) < 0.95 (molar ratio). This is because, when this formula is satisfied, Cu₍₂₋ₓ₎Se can be prevented from being excessively incorporated into the CIGS light absorbing layer 3, and moreover, the entire layer can be made deficient slightly in Cu. In addition, the ratio between Ga and In, which are elements belonging to the same group, preferably falls within the range of 0.10 < Ga/ (Ga + In) < 0.40 (molar ratio). In this embodiment, the CIGS light absorbing layer 3 is Cu/Group III = 0.89 and Ga/Group III = 0.31 in composition (molar ratio).

Further, for the formation of the buffer layer 4 on the CIGS light absorbing layer 3, the buffer layer 4 is formed by a sputtering method with the use of a high-frequency RF power source or a high-frequency RF power source and a direct-current (DC) power source in combination, while two cathode targets for sputtering are arranged to be opposed to each other on both sides of an imaginary central axis assumed to extend perpendicularly to a surface of the substrate 1 over which the CIGS light absorbing layer 3 is stacked. This is the greatest feature of the present invention.

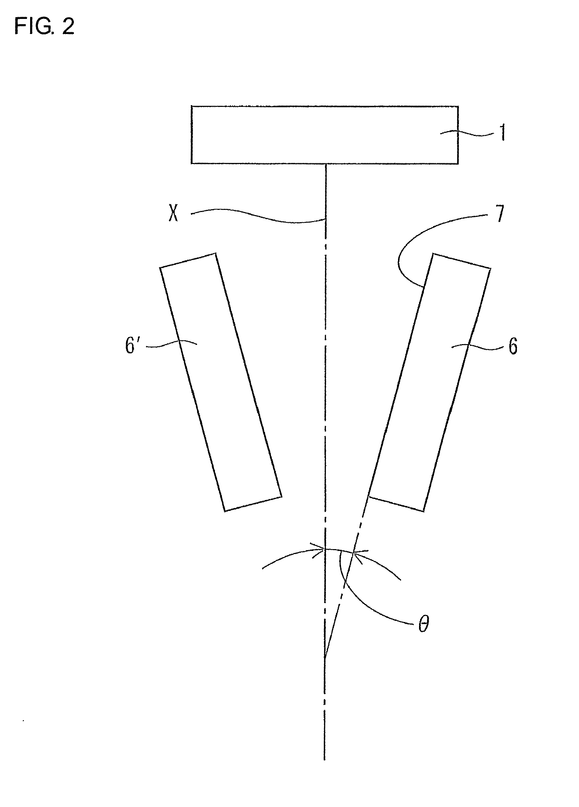

To describe the formation of the buffer layer 4 more fully, first, two cathode targets for sputtering are prepared which have a composition of Zn_{0.85}Mg_{0.15}O, and these two cathode targets 6, 6' are arranged to be opposed to each other on both sides of an imaginary central axis X supposed to extend perpendicularly from a surface of the substrate 1 over which the CIGS light absorbing layer 3 is stacked, as shown in FIG. 2. In this embodiment, the both cathode targets 6, 6' are arranged in a substantially V-shaped form which spreads toward the surface of the substrate 1 over which the CIGS light absorbing layer 3 is stacked, and the degree of substantially V-shaped form for the both cathode targets 6, 6' is adapted to have an angle θ of 10° made by the imaginary central axis and an opposed surface 7 of the cathode target. In addition, the application of an electric power to the both cathode targets 6, 6' is carried out with the use of a high-frequency RF power source. It is to be noted the illustration of the rear electrode layer 2 and CIGS light absorbing layer 3 formed over the substrate 1 is omitted in FIG. 2 (the same applies to the following drawings).

Next, the transparent electrode layer 5 formed on the buffer layer 4 is composed of an ITO of 200 nm in thickness, and formed under a sputtering rate of 20 nm/min by a sputtering method with the use of an ITO target (In₂O₃ : 90 [at. %], SnO₂: 10 [at. %]) and a high-frequency RF power source. This transparent electrode layer 5 can be formed by a vapor deposition method, a metalorganic chemical vapor deposition method (MOCVD method), etc., besides the sputtering method mentioned above, and moreover, the light transmission of the transparent electrode layer 5 preferably exceeds 80% with respect to a wavelength of 550 nm, and in this embodiment, the light transmission of the transparent electrode layer 5 is 90% with respect to a wavelength of 550 nm.

Through these steps, the CIGS solar cell can be obtained which has the rear electrode layer 2, CIGS light absorbing layer 3, buffer layer 4, and transparent electrode layer 5 formed over the substrate 1.

According to this manufacturing method, the buffer layer 4 is formed by the special sputtering method, thus following the formation of the CIGS light-absorbing layer 3, the buffer layer 4 can be formed continuously under vacuum, and the production efficiency of the CIGS solar cell can be increased. In addition, the buffer layer 4 is formed by the sputtering method with the use of a high-frequency RF power source, while the two cathode targets 6, 6' for sputtering are prepared, and arranged to be opposed to each other on both sides of the imaginary central axis X extending perpendicularly from the surface of the substrate 1 over which the CIGS light absorbing layer 3 is stacked. Thus, a balance can be achieved between the formation of the buffer layer 4 at high speed and the reduction in damage caused to the CIGS light absorbing layer 3. Moreover, because the two opposed cathode targets 6, 6' are arranged in a substantially V-shaped form which spreads toward the surface of the substrate 1 over which the CIGS light absorbing layer 3 is stacked, the buffer layer 4 can be formed at higher speed, and the CIGS solar cell can be further reduced in cost.

It is to be noted that while the degreased SUS 430 is used as the substrate 1 in the embodiment described above, glass substrates, metal substrates, resin substrates, etc. can be used instead of the SUS 430. The glass substrates include low alkali glass which has an extremely low content of alkali metal elements, alkali-free glass containing no alkali metal elements, and soda-lime glass. However, in the case of using the low alkali glass, alkali-free glass, metal substrates, and resin substrates, it is desirable to add a minute amount of Na during or after the formation of the CIGS light absorbing layer 3 as described in the above embodiment.

In addition, while the substrate 1 is 50 µm in thickness in the embodiment described above, the present invention is not limited to this thickness, but any thickness may be adopted. Above all, the thickness of the substrate 1 preferably falls within the range of 5 to 200 µm, more preferably within the range of 10 to 100 µm. More specifically, this is because an excessively large thickness has the possibility of losing the flexibility of the CIGS solar cell, increasing the stress applied when the cell is bent, and damaging the laminated structure such as the CIGS light absorbing layer 3, whereas an excessively small thickness has a tendency to increase the defects rate of a product of the CIGS solar cell due to the substrate 1 buckling in manufacturing the CIGS solar cell.

Moreover, while a sheet type of substrate is used as the substrate 1 in the embodiment described above, the present invention is not limited to this type, but any substrate having another shape may be used. Above all, the use of a substrate in an elongated shape can manufacture a CIGS solar cell with the use of a roll-to-roll method or a stepping roll method, and further increase the productivity. It is to be noted that the "elongated shape" mentioned above refers to a shape that is 10 times or more as long in the length direction as in the width direction, and a shape that is 30 times or more as long in the length direction as in the width direction is more preferably used.

Furthermore, while the rear electrode layer 2 is formed from a single layer composed of Mo in the embodiment described above, tungsten, Ti, Cr, etc. can be formed into single layers or multiple layers, besides this single layer of Mo. In addition, the thickness (the total thickness of respective layers in the case of multiple layers) can be also set arbitrarily, but above all, preferably falls within the range of 10 to 1000 µm.

Moreover, there is no need to provide the rear electrode layer 2 when the substrate 1 has the function of the rear electrode layer 2 (has conductivity). Further, thermal diffusion of impurities derived from the substrate 1 degrades the performance of the CIGS compound solar cell, and thus, for the purpose of preventing this thermal diffusion, a metal diffusion preventing layer (not shown) may be provided between the substrate 1 and the CIGS light absorbing layer 3 (over the substrate 1 or the rear electrode layer 2). Such a metal diffusion preventing layer can be formed, for example, by a sputtering method, a vapor deposition method, a CVD method, a sol-gel method, a liquid-phase deposition method, or the like with the use of Cr, Ni, NiCr, Co or the like.

In addition, while the CIGS light absorbing layer 3 is 2 µm in thickness in the embodiment described above, the present invention is not limited to this thickness, but any thickness may be adopted. Above all, the thickness thereof preferably falls within the range of 1.0 to 3.0 µm, further preferably falls within the range of 1.5 to 2.5 µm. This is because an excessively small thickness of the CIGS light absorbing layer 3 has a tendency to reduce the amount of light absorption, and degrade the performance of the CIGS solar cell, whereas an excessively large thickness has a tendency to increase the amount of time for the formation of the CIGS light absorbing layer 3, thereby resulting in poor productivity.

Further, while the buffer layer 4 is formed with the use of the cathode targets 6, 6' for sputtering, which have a composition of Zn_{0.85}Mg_{0.15}O, in the embodiment described above, CdS, ZnMgO, ZnMgCaO, ZnMgSrO, ZnSrO, ZnO, ZnS, Zn(OH)₂, In₂O₃, and In₂S₃, and mixed crystals thereof such as Zn(O, S, OH) and Zn(O, S) can be used as the cathode targets 6, 6', in addition to this composition. In addition, when the cathode targets 6, 6' differ from the obtained layer (buffer layer 4) in composition, the cathode targets 6, 6' may be used which have a composition containing a higher proportion of deficient element in advance. Moreover, while the buffer layer 4 is formed as a single layer in the embodiment described above, multiple layers may be formed therefor.

In addition, while the cathode targets 6, 6' are arranged in the substantially V-shaped form which spreads toward the substrate 1 so that the angles θ made by the imaginary central axis X and the cathode targets 6, 6' are each 10° as the level of the substantially V-shaped form as shown in FIG. 2 in the sputtering for the formation of the buffer layer 4 in the embodiment described above, the angles θ are not limited to this example. However, the angles θ preferably fall within the range of 5° to 10°, because the buffer layer 4 can be formed with less power.

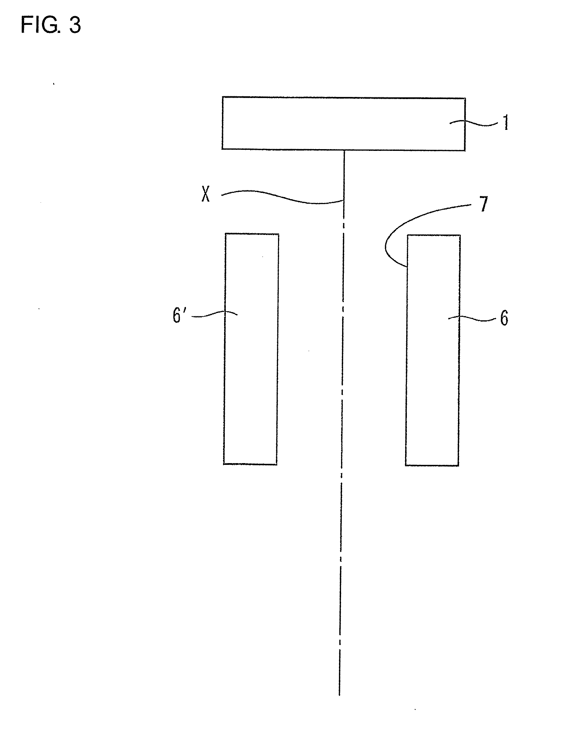

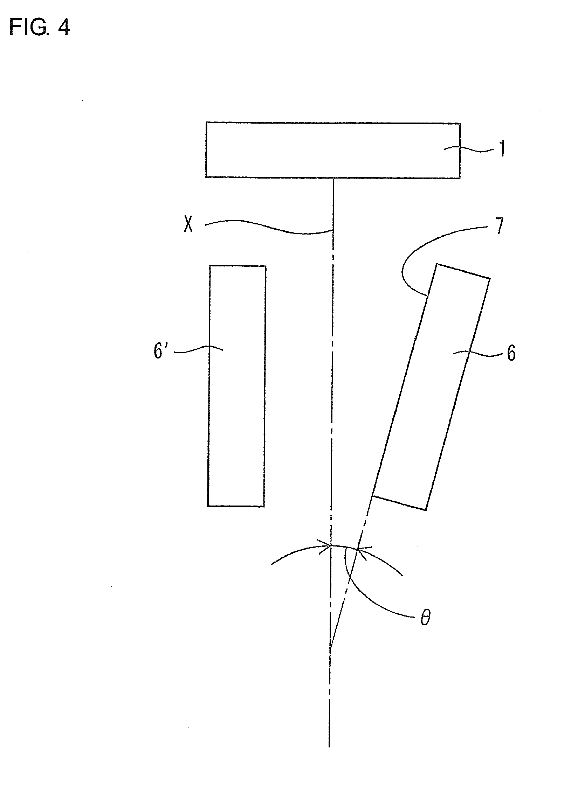

Moreover, depending on the composition of the cathode targets 6, 6' and the condition for sputtering, the both cathode targets 6, 6' may be arranged parallel to each other as shown in FIG. 3, rather than the cathode targets 6, 6' arranged in a substantially V-shaped form which spreads toward the substrate 1. Alternatively, as shown in FIG. 4, only one of the cathode targets (the cathode target 6 in this example) may be arranged in a form inclined at an angle θ with respect to the imaginary central axis X.

Further, while a high-frequency RF power source is used for the application of an electric power to the both cathode targets 6, 6' in the sputtering for the formation of the buffer layer 4 in the embodiment described above, a high-frequency RF power source and a direct-current (DC) power source may be used in combination in place of the embodiment. Using the direct-current power source (DC) and the high-frequency RF power source in combination can increase the sputtering rate with less input power (power consumption), and further suppress plasma damage such as an altered surface of the CIGS light absorbing layer 3 and decrease crystallinity of the buffer layer 4, as compared with a case of carrying out the application with only a high-frequency RF power source.

In contrast, when the application of an electric power to the both cathode targets 6, 6' is carried out with a direct-current power (DC) alone, the discharge voltage is increased to accordingly increase the kinetic energy of particles and ions incident into the substrate 1 and the buffer layer 4 being formed. Therefore, there is unfavorably a possibility that the particles and ions will be implanted onto the surface of the CIGS light absorbing layer 3 to resputter the surface of the CIGS light absorbing layer 3 and alter the surface condition of the CIGS light absorbing layer 3. In addition, high-energy particles and ions are believed to increase the probability of crystal nucleation in the buffer layer 4 being formed, and to be less likely to result in uniformly oriented growth, but more likely to result in random crystalline orientation.

In addition, while the ITO is used as the transparent electrode layer 5 in the embodiment described above, IZO, aluminum-containing zinc oxide (Al:ZnO), etc. can be used in addition to this ITO. In addition, the thickness thereof can be also set arbitrarily, but preferably falls within the range of 50 to 300 nm.

### [Examples]

Next, examples will be described in conjunction with comparative examples. However, the present invention is not to be considered limited to the following examples.

### [Example 1]

### (Formation of Rear Electrode Layer)

First, over a surface of a substrate composed of degreased SUS 430 (20 mm in width x20 mm in length × 50 µm in thickness), a rear electrode layer composed of Mo of 0.8 mm in thickness was formed at a sputtering rate of 60 nm/min by using a magnetron sputtering system (from ULVAC, Inc. , Model Number SH-450) with the use of argon for a discharge gas and with the use of a direct-current (DC) power source for providing a sputtering pressure of 1 Pa.

### (Formation of CIGS Light Absorbing Layer)

Next, a CIGS light absorbing layer was formed on the rear electrode layer formed above. More specifically, while Ga (950°C), In (780°C), Cu (1100°C), and Se (140°C) were each placed as vapor deposition sources in a chamber of a vacuum deposition system, the substrate was heated up to 550°C at a rate of temperature increase of 550°C/h, with the degree of vacuum adjusted to 1 × 10⁻⁴ Pa in the chamber. In this case, the CIGS light absorbing layer composed of a chalcopyrite compound was formed on the rear electrode layer, in such a way that the vapor deposition sources were respectively heated so as to reach the temperatures in the parentheses, for simultaneously evaporating these elements. The obtained CIGS light absorbing layer was Cu/Group III = 0.89 and Ga/Group III = 0.31 in composition (atom number %), and 2.1 µm in film thickness.

### (Formation of Buffer Layer)

Subsequently, a buffer layer of 70 mm in thickness was formed on the CIGS light absorbing layer formed above. The buffer layer was formed under the following condition with the use of a facing target sputtering system (angle θ = 10°) with the two cathode targets shown in FIG. 2 arranged in a substantially V-shaped form. More specifically, a high-frequency (RF) power source was used under the conditions of 0.3 Pa in sputtering pressure and 15 nm/min in sputtering rate, through the use of Ar for the discharge gas in sputtering, with the use of targets of Zn_{0.85}Mg_{0.15}O composition as the cathode targets. The composition analysis of the cathode targets showed a mixture of about 3% (atomic number %) of Ca in Mg.

### (Formation of Transparent Electrode Layer)

Furthermore, a transparent electrode layer was formed on the buffer layer formed above. The transparent electrode layer was formed under the following condition with the use of a magnetron sputtering system (from ULVAC, Inc., Model Number SH-450). More specifically, a target of ITO (In₂O₃: 90 [atomic number %], SnO₂: 10 [atomic number %]) composition was used as a cathode target, and an Ar gas and an O₂ gas with 1/10 of the Ar flow rate were used in combination for the discharge gas in sputtering. Then, the transparent electrode layer of 200 nm in thickness was formed at a power density of 1.6 W/cm², a sputtering pressure of 0.3 Pa, and a sputtering rate of 20 nm/min with the use of a high-frequency (RF) power source, thereby providing a CIGS solar cell according to Example 1.

### [Examples 2 and 3]

Except that the sputtering rate was changed as shown in Table 1 below in the formation of the buffer layer, CIGS solar cells according to Examples 2 and 3 were obtained in the same way as in Example 1.

### [Examples 4 to 6]

Except that the sputtering rate was changed as shown in Table 1 below with the use of a high-frequency RF power source and a direct-current (DC) power source in combination in the formation of the buffer layer, CIGS solar cells according to Examples 4 to 6 were obtained in the same way as in Example 1.

### [Examples 7 and 8]

Except that the degree (angle θ) of the substantially V-shaped form of the two cathode targets shown in FIG. 2 was changed as shown in Table 1 below in the formation of the buffer layer, CIGS solar cells according to Examples 7 and 8 were obtained in the same way as in Example 1.

### [Example 9]

Except that a change was made for the use of a facing target sputtering system with two cathode targets arranged parallel to each other as shown in FIG. 3 in the formation of the buffer layer, a CIGS solar cell according to Example 9 was obtained in the same way as in Example 1.

### [Comparative Examples 1 to 6]

Except that the power source and sputtering rate were changed as shown in Table 1 below with the use of a general-purpose magnetron sputtering system (from ULVAC, Inc., SH-450: a sheet of cathode target placed so as to be parallel to a surface of a substrate over with the CIGS light absorbing layer is stacked) in the formation of the buffer layer, CIGS solar cells according to Comparative Examples 1 to 6 were obtained in the same way as in Example 1.

### [Comparative Examples 7 to 9]

Except that the sputtering rate was changed as shown in Table 1 below the with the use of a direct-current (DC) power source in the formation of the buffer layer, CIGS solar cells according to Comparative Examples 7 to 9 were obtained in the same way as in Example 1.

### <Measurement of Conversion Efficiency and Calculation of Conversion Efficiency Ratio>

For each of the CIGS solar cells according to Examples 1 to 9 and Comparative Examples 1 to 9 described above, 20 pieces were prepared, and irradiated with quasi-sunlight (AM 1.5) to measure the conversion efficiency for each piece with the use of an IV measurement system (from Yamashita Denso Corporation) . The averages for the obtained conversion efficiencies and the conversion efficiency ratios in the case of regarding Comparative Example 4 as a reference (100) are each calculated, and shown together in Table 1 below.

**[Table 1]**

| | Sputtering System | Power Source | Sputtering Rate (nm/min) | Conversion Efficiency (%) | Conversion Efficiency Ratio (%) |
|---|---|---|---|---|---|
| Example 1 | Opposed Type (V shape) (Angle θ = 10°) | RF | 15 | 5.2 | 143 |
| Example 2 | Opposed Type (V shape) (Angle θ = 10°) | RF | 5 | 4.2 | 114 |
| Example 3 | Opposed Type (V shape) (Angle θ = 10°) | RF | 25 | 5.1 | 140 |
| Example 4 | Opposed Type (V shape) (Angle θ = 10°) | RF + DC | 5 | 4.2 | 115 |
| Example 5 | Opposed Type (V shape) (Angle θ = 10°) | RF + DC | 15 | 5.6 | 153 |
| Example 6 | Opposed Type (V shape) (Angle θ = 10°) | RF + DC | 25 | 5.9 | 161 |
| Example 7 | Opposed Type (V shape) (Angle θ = 5°) | RF | 15 | 5.1 | 138 |
| Example 8 | Opposed Type (V shape) (Angle θ = 15°) | RF | 15 | 5.2 | 141 |
| Example 9 | Opposed Type (Parallel) | RF | 15 | 5.3 | 143 |
| Comparative Example 1 | Magnetron | DC | 5 | 0.7 | 20 |
| Comparative Example 2 | Magnetron | DC | 15 | 0.4 | 10 |
| Comparative Example 3 | Magnetron | DC | 25 | 0.4 | 10 |
| Comparative Example 4 | Magnetron | RF | 5 | 3.7 | 100 |
| Comparative Example 5 | Magnetron | RF | 15 | 3.3 | 89 |
| Comparative Example 6 | Magnetron | RF | 25 | 2.1 | 57 |
| Comparative Example 7 | Opposed Type (V shape) (Angle θ = 10°) | DC | 5 | 1.7 | 35 |
| Comparative Example 8 | Opposed Type (V shape) (Angle θ = 10°) | DC | 15 | 0.9 | 20 |
| Comparative Example 9 | Opposed Type (V shape) (Angle θ = 10°) | DC | 25 | 0.7 | 20 |

| | | | | | |
|---|---|---|---|---|---|
| RF: High-Frequency Power Source DC: Direct-Current Power Source RF + DC: Combination of High-Frequency Power Source with Direct-Current Power source Superimposed | | | | | |

The results of measuring the conversion efficiency as described above have shown that Examples 1 to 9 are excellent in conversion efficiency, with an average conversion efficiency above 4% in each of the examples. This is also clear from the fact that the conversion efficiency ratio is 114% or higher in each of Examples 1 to 9, as compared with Comparative Example 4 with the buffer layer formed with the use of the general-purpose sputtering system. However, Examples 8 and 9 have excellent performance, but requires more electric power and time for the formation of the buffer layer, and have a tendency to increase the manufacturing cost.

While specific embodiments in the present invention have been given in the examples described above, the examples by way of example only are not to be considered construed in a limited way. Various modifications that are obvious to one skilled in the art are intended within the scope of the present invention.

### INDUSTRIAL APPLICABILITY

The compound solar cell obtained by the manufacturing method according to the present invention can be used in various fields, because the conversion efficiency is extremely high in spite of the thinness.

### DESCRIPTION OF REFERENCE SIGNS

- 1: substrate
- 6, 6': cathode target
- X: imaginary central axis

## Claims

1. A method for manufacturing a compound solar cell comprising at least a Group I-III-VI compound semiconductor layer, a buffer layer, and a transparent electrode layer in this order over a substrate, the method comprising:
forming the buffer layer by a sputtering method with a high-frequency RF power source or a high-frequency RF power source and a direct-current (DC) power source in combination,
wherein, during sputtering, two cathode targets for sputtering are arranged to be opposed to each other on both sides of an imaginary central axis extending perpendicularly from a surface of the substrate over which the Group I-III-VI compound semiconductor layer is stacked.

2. The method for manufacturing a compound solar cell according to claim 1, wherein the two cathode targets are arranged in a substantially V-shaped form spreading toward the surface of the substrate over which the Group I-III-VI compound semiconductor layer is stacked.

3. The method for manufacturing a compound solar cell according to claim 1, wherein the two cathode targets are arranged parallel to each other.
